# EUROPEAN PATENT APPLICATION

(11) **EP 2 889 914 A1**
(43) Date of publication of application: **01.07.2015**
(21) Application number: 14156452.6
(22) Date of filing: 25.02.2014
(51) Int. Cl.: H01L 29/06, H01L 29/739

(54) **Bipolar semiconductor device**

(30) Priority: 30.12.2013 CH 21652013
(71) Applicant: ABB Technology AG, 8050 Zürich (CH)
(72) Inventor: Bauer, Friedhelm, 6714 Semione (CH)
(74) Representative: ABB Patent Attorneys

(57) **Abstract**

An semiconductor device comprises a semiconductor slab (1), in particular a semiconductor wafer or semiconductor die, said semiconductor slab (1) having a first main side (101) and a second main side (102), said second main side (102) being parallel to the first main side (101) at a distance with respect to a first direction. The semiconductor device further comprises: an insulated gate bipolar transistor cell comprising an emitter electrode (431, 431') formed on the first main side (101) and a collector electrode (41) formed on the second main side (102), the IGBT cell further comprising between the first main side (101) and the second main side (102): a bulk layer (10) of a first conductivity type extending in the first direction between a distance *d*_{b1} from the first main side (101) with *d*_{b1} >= 0 and a distance *d*_{b2} from the first main side (101) with *d*_{b2} > *d*_{b1}, and in a second direction perpendicular to the first direction, said bulk layer (10) being adjacent to the first main side (101), a collector layer (3) of a second conductivity type, which is different from the first conductivity type, said collector layer being adjacent, preferably contiguous, to the second main side (102), and electrically connected to the collector electrode (41), the IGBT cell further comprising a base region (421, 421') of the second conductivity type, provided between the first main side (101) and the bulk layer (10), an emitter region (422, 422') of the first conductivity type, provided between the first main side (101) and the base region (421, 421'), an enhancement region (423, 423') of the first conductivity type, provided between the bulk layer (10) and the base region (421, 421'), wherein the emitter electrode (431, 431') is electrically connected to the emitter region (422, 422') and the base region (421, 421'), and a gate electrode (433) is arranged adjacent to the first main side (101), and electrically insulated from the semiconductor slab (1) and from the emitter electrode (431, 431'), wherein a plurality of, preferably at least 4, floating regions (11) of a second conductivity type are provided in the bulk layer (10) between a first distance *d*_{f1} from the first main side (101) and a second distance *d*_{f2} from the first main side (101), and spaced apart from one another with respect to the second direction.

## Description

### Technical Field

The invention relates to the field of power semiconductor devices and more particularly to insulated gate bipolar transistors according to the preamble of claim 1.

### Background Information

Soft punch-through (SPT) integrated gate bipolar transistors (IGBTs) have been known for many years. Key feature of the SPT IGBT is a so called buffer layer, which is provided between a drift layer and a collector layer of an IGBT, and has both a significantly higher doping concentration of the same conductivity type (usually n) and a significantly lower thickness than the drift layer. A significant reduction in on-state losses may thus be achieved in comparison to both standard punch-through and non-punch-through IGBT designs, while maintaining advantages like relatively low cost, ruggedness, high input capacitance, high thermal resistance, etc., as described in the article "Soft Punch Through (SPT) - Setting new Standards in 1200 V IGBT" by S. Dewar, S. Linder, C. von Arx, A. Mukhitinov and G. Debled, PCIM 2000 Europe: Official Proceedings of the Forty-First International Power Conversion Conference, June 6-8, 2000, Nuremberg, Germany, which is hereby included by reference in its entirety.

Several years ago, improved soft punch-through integrated gate bipolar transistors were suggested, which have become known as SPT+ IGBTs. As described in the article "1200 V SPT+ IGBT and Diode chip-set for high DC-link Voltage applications" by M. Cammarata, A. Kopta, M. Rahimo, S. Klaka, F. Richter and S. Geissman in Proceedings of PCIM Europe 2009, May 12-14, 2009, Nuremberg, Germany, which is hereby included by reference in its entirety, an n-doped enhancement region (sometimes also referred to as enhancement layer) is provided which surrounds a p-doped well (often also referred to as a p-body or a p-doped body region), and also a p-doped channel region. Introduction of the n-doped enhancement allowed for significant further reduction in on-state losses due a reduction of an on-state voltage drop *V*_{ce,on} down to values that previously were only achievable with so called trench IGBT designs.

However, in the process of the IGBT technology development just described, it was found that trade-offs emerge between reduced on-state losses and a device breakdown voltage *V*_{br}.

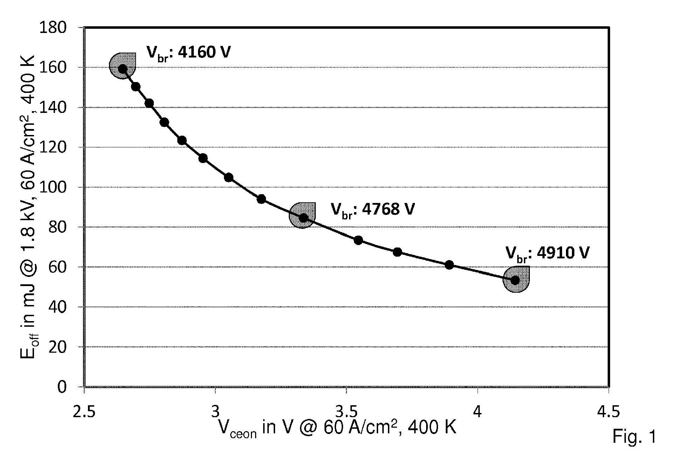

A first type of trade-off, to be referred to as TYPE1 trade-off throughout this document, corresponds to a choice of a doping concentration *N*_{c} of a p-doped (for an IGBT with an n-doped drift layer) collector layer (located on a second main side of a semiconductor slab, said second main side located opposite a first main side on which gate and emitter electrodes are provided for a vertical IGBT structure) and is illustrated in Fig. 1, which shows a TYPE1 trade-off curve, i.e. plot of a turn-off switching loss *E*_{off} against on-state voltage drop *V*_{ce,on}, obtained through numerical simulation of a current, i.e. prior art 3.3 kV SPT+ IGBT having a total silicon semiconductor slab thickness of *D* = 370 µm and a cell pitch *W_{cell}* = 80 µm, assuming hard inductive turn-off of 60 A/cm versus a DC voltage *V*_{DC} = 1800 V at a device temperature of 400 K, wherein a circuit used for the simulation mimics a typical 3.3 kV application; and which will serve as a reference for comparison with semiconductor devices in accordance with the present invention. For weakly p-doped collector (e.g. with *N*_{c} = 1.25 - 10¹⁷cm⁻³ as represented by the rightmost dot on the curve shown in Fig. 1), on-state voltage drop is large, but a turn-off switching loss *E*_{off} is low (due to fast device switching behavior). Towards an opposite end of the curve, lower on-state voltage drops may be achieved, albeit at the cost of significantly increased switching losses. A fact rarely mentioned regards the breakdown voltage variation underlying such variations of the collector doping concentration *N*_{c}: a more highly doped collector layer results in a higher current gain of a PNP bipolar part of the IGBT. The same current gain increase causes an amplification of a leakage current during blocking. Assuming a fixed current level of 0.01 A·cm⁻² for definition of the breakdown voltage, *V*_{br} thus decreases from right to left along the curve shown in Fig. 1, where three breakdown voltages are indicated along the 3.3 kV SPT+ trade-off curve for illustration. Note that while *V*_{br} changes relatively slowly along a lower portion on the right hand side of the trade-off curve, a decrease in *V*_{br} becomes significant on a rising portion on the left hand side of the trade-off curve, which may cause a restriction of the useable range of the trade-off curve.

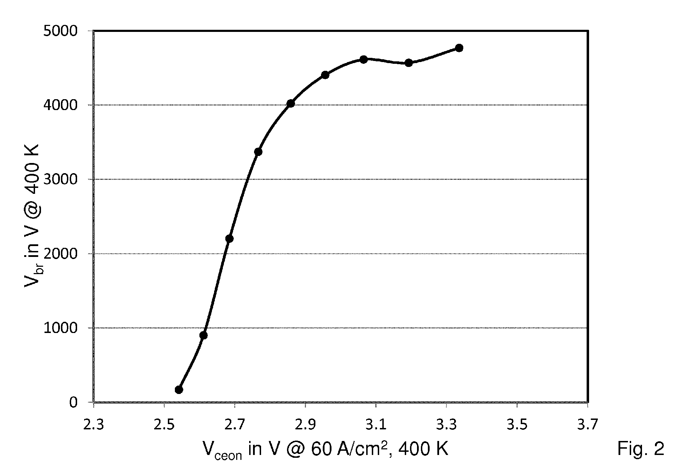

Another type of trade-off, to be referred to as TYPE2 trade-off, corresponds to a choice of a doping concentration *N*ₑₙₕ of the n-enhancement region. Fig. 2 shows a TYPE2 trade-off curve, i.e. plot of *V*_{br} against *V*_{ce,on}, as obtained through numerical simulation of the same 3.3 kV prior art SPT+ IGBT that was used for Fig. 1, again assuming hard inductive turn-off of 60 A/cm versus *V*_{DC} = 1800 V at a device temperature of 400 K, and the same circuit mimicking a typical 3.3 kV application. Doping concentration of the p-doped collector layer was kept fixed at *N*_{c} = 3.0 ·10¹⁷cm⁻³. A set of on-state voltage drops was computed and set in relation with corresponding breakdown voltages, starting with a doping concentration of the n-enhancement region of *N*ₑₙₕ = 1.0 -10¹⁶cm⁻³, corresponding to the rightmost dot on the curve shown in Fig. 2. As *N*ₑₙₕ is increased, both on-state voltage drop *V*_{ce,on} and breakdown voltage *V*_{br} decrease. The leftmost dot on the curve shown in Fig. 2 was obtained for a doping concentration of the n-enhancement region of *N*ₑₙₕ = 1.0·10¹⁷cm⁻³. A beneficial range within which on-state voltage drop *V*_{ce,on} may be reduced without negative impact on the breakdown voltage is thus limited to on-state voltage drops above 3 V, corresponding to a doping concentration of the n-enhancement region of *N*ₑₙₕ = 5.0·10¹⁶cm⁻³.

### Disclosure of Invention

It is an object of the invention to provide an integrated gate bipolar transistors which overcomes the disadvantages as discussed above

This object is achieved by a semiconductor device according to claim 1.

An inventive semiconductor device comprises a semiconductor slab, in particular a semiconductor wafer or semiconductor die, said semiconductor slab having a first main side and a second main side, said second main side being parallel to the first main side at a distance with respect to a first direction. The semiconductor device further comprises: an insulated gate bipolar transistor cell comprising an emitter electrode formed on the first main side and a collector electrode formed on the second main side, the IGBT cell further comprising between the first main side and the second main side: a bulk layer of a first conductivity type extending in the first direction between a distance *d*_{b1} from the first main side with *d*_{b1} >= 0 and a distance *d*_{b2} from the first main side with *d*_{b2} > *d*_{b1}, and in a second direction perpendicular to the first direction, said bulk layer being adjacent to the first main side, a collector layer of a second conductivity type, which is different from the first conductivity type, said collector layer being adjacent, preferably contiguous, to the second main side, and electrically connected to the collector electrode, the IGBT cell further comprising a base region of the second conductivity type, provided between the first main side and the bulk layer, an emitter region of the first conductivity type, provided between the first main side and the base region, an enhancement region of the first conductivity type, provided between the bulk layer and the base region, wherein the emitter electrode is electrically connected to the emitter region and the base region , and a gate electrode is arranged adjacent to the first main side, and electrically insulated from the semiconductor slab and from the emitter electrode, wherein a plurality of, preferably at least 4, floating regions of a second conductivity type are provided in the bulk layer between a first distance *d*_{f1} from the first main side and a second distance *d*_{f2} from the first main side, and spaced apart from one another with respect to the second direction.

Further preferred embodiments of the inventive subject matter are disclosed in the dependent claims.

### Brief Description of Drawings

The subject matter of the invention will be explained in more detail in the following text with reference to the attached drawings, in which:
- Fig. 1: shows a TYPE1 trade-off curve for a prior art 3.3kV SPT+ IGBT;
- Fig. 2: shows a TYPE2 trade-off curve for a prior art 3.3kV SPT+ IGBT;
- Fig. 3: shows a sectional view of an individual, planar, integrated gate bipolar transistor cell as comprised by a first embodiment of a semiconductor device in accordance with the present invention;
- Fig. 4: shows simulation results represented by TYPE2 trade-off curves for semi-conductor devices in accordance with the present invention based on an IGBT cell design as shown in Fig. 3;
- Fig. 5: shows simulation results represented by a TYPE1 trade-off curve for a semi-conductor device in accordance with the present invention based on the IGBT cell design as shown in Fig. 3;
- Fig. 6: shows an equivalent electric circuit model related to a semiconductor device in accordance with the present invention as shown in Fig. 3;
- Fig. 7: shows simulation results represented by TYPE1 trade-off curves;
- Fig. 8: shows simulation results represented by TYPE1 trade-off curves;
- Fig. 9: shows a sectional view of an individual, trench integrated gate bipolar transistor cell, as comprised by a second embodiment of a semiconductor device in accordance with the present invention;
- Fig. 10: shows simulation results represented by a TYPE1 trade-off curve for the a second embodiment of a semiconductor device in accordance with the present invention based on trench IGBT cell designs as shown in Fig. 9;
- Fig. 11: shows simulation results represented by TYPE1 trade-off curves *E*_{off} vs. *V*_{ce,on} for a trench IGBT cell design;
- Fig. 12: shows simulation results represented TYPE2 trade-off curves *V*_{br} vs. *V*_{ce,on} for both planar and trench IGBT cell designs;
- Fig. 13: schematically shows partial top views of cuts at *x*=-*d*_{float} parallel to the *y*-*z*-plane through various semiconductor devices in accordance with the present invention.

The reference signs used in the figures and their meaning are summarized in the list of reference signs. Generally, alike or alike-functioning parts are given the same reference signs. The described embodiments are meant as examples and shall not confine the invention.

### Modes for Carrying out the Invention

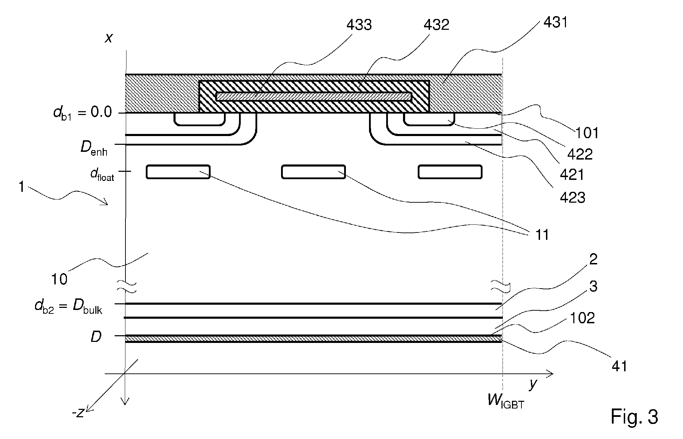

Fig. 3 shows a sectional view of an individual, planar, integrated gate bipolar transistor (IGBT) cell, as comprised by a first embodiment of a semiconductor device in accordance with the present invention. The IGBT cell is formed in and partially around a semiconductor slab 1, which was e.g. obtained from a Silicon wafer through a plurality of process steps, generally including thinning, layer growing, implant and deposition and diffusion of dopants, and/or dicing. The semiconductor slab has a first main side 101 located at *x*=0 and a second main side 102, said second main side 102 being arranged parallel to the first main side 101 at a distance *D* in (*x*)-direction, i.e. at *x* = *D*. An (n-)-doped bulk layer 10, an (n+)-doped buffer layer 2, and a (p+)-doped collector layer 3 are located between the first main side 101 and the second main side 102, and extend in a direction at least essentially parallel to the first and second main sides 101, 102 and parallel to one another. The bulk layer 10 is (n-)-doped with an at least essentially homogeneous background doping concentration *N*_{D0}, preferably in a range between 5.0·10¹² cm⁻³ and 5.0·10¹⁵ cm⁻³, most preferably between 1.0·10¹³ cm⁻³ and 1.0·10¹⁴ cm⁻³, and has a thickness *D*_{bulk} preferably between 100 µm and 1.0 mm. A p-doped base region 421 having a thickness and extending to a depth *D*_{base} from the first main side 101, wherein *D*_{base} << *D*_{bulk}, is formed between the first main side 101 and the bulk layer 10 at a peripheral area of the IGBT cell, and adjacent to the first main side 101. An n-doped, preferably (n+)-doped, emitter region 422 is formed between the p-doped base region 421 and the first main side 101, and contiguous to the first main side 101. An upper side of the p-doped base region 421 is contiguous to the first main side outside of an area in which the n-doped emitter region 422 is formed. An n-doped enhancement region 423 extending to a depth *D*ₑₙₕ from the first main side 101, wherein *D*_{base} < *D*ₑₙₕ << *D*_{bulk} is formed between the p-doped base region 421 and the bulk layer 10, and adjacent to the first main side 101, thus separating the p-doped base region 421 from the bulk layer 10. An upper side of the n-doped enhancement region 423 is contiguous to the first main side outside of an area in which the p-doped base region 421 is formed.

A collector electrode 41 is provided on the second main side 102, adjacent and contiguous to the collector layer 3, and with an ohmic contact formed between drain electrode 41 and collector layer 3. An emitter electrode 431 is provided on a peripheral area of the IGBT cell contiguous to the first main side 101; and also with an ohmic contact formed between emitter electrode 431 and semiconductor slab 1, in particular between the emitter electrode 431 and both emitter region 422 and p-doped base region 421. An insulator 432, preferably SiO₂, is formed on and contiguous to the first main side 101 in a horizontal central area of the IGBT cell. A planar gate electrode 433 is disposed above said horizontal central area of the IGBT cell, and electrically insulated from semiconductor slab 1 by the insulator 432. Bulk layer 10 is contiguous to first main side 101 in an area underneath gate electrode 433. Emitter electrode 431 is also referred to as cathode or cathode electrode, collector electrode 41 as anode or anode electrode.

A plurality of isolated, p-doped, preferably (p+)-doped, floating regions 11 having a net doping concentration *N*_{float} > *N*_{D0} are formed in the bulk layer between a first distance *d*_{f1} and a second distance *d*_{f2} from the first main side 101, i.e. at a depth *x* = *d*_{float} with *d*_{float} = (*d*_{f2} - *d*_{f1})/2 and *D*ₑₙₕ < *d*_{f1} < *d*_{f2} << *D*_{bulk}, wherein preferably 5 *D*_{base} < *d*_{float} < 20 *D*_{base} and/or 2*D*ₑₙₕ < *d*_{float} < 10*D*ₑₙₕ also hold. In a vertical direction, the p-doped floating regions 11 have a thickness *D*_{f} := *d*_{f2} - *d*_{f1} with *D*_{f} << *D*_{bulk}, preferably *D*_{f} < *D*_{bulk}/10, most preferably *D*_{f} < *D*_{bulk}/100. In a first horizontal direction, corresponding to a *y*-direction in Fig. 3, the p-doped floating regions 11 have a width *w*_{f}, typically in a range 0.5 µm < *w*_{f} < 10 µm, preferably 5 µm < *w*_{f} < 8 µm. Neighboring p-doped floating regions 11 are spaced apart from one another with respect to the *y*-direction with a spacing *s*_{f} typically in a range 1 µm < *s*_{f} < 10 µm, preferably 2 µm < *s*_{f} < 5 µm.

An actual IGBT-type semiconductor device in accordance with the present invention comprises a plurality, typically several hundred to a few thousands, of individual cells as shown in Fig. 3, arranged contiguous to one another in y-direction, each cell having a width *w*_{IGBT} typically in a range 20 µm < *w*_{IGBT} < 200 µm, preferably 40 µm < *w*_{IGBT} < 100 µm. The laterally contiguous bulk layers 10 of the individual IGBT cells thus form a contiguous bulk layer in the IGBT-type semiconductor device. Likewise, the p-doped floating regions 11 form a buried grid with a period Λ*_{y}* = *w*_{f} + *s*_{f} within the contiguous bulk layer of the IGBT-type semiconductor device.

The buried grid of p-doped floating regions 11 may be regarded as a floating sublayer which is located within the contiguous bulk layer of the actual IGBT-type semiconductor device, and which separates a first bulk sublayer located above the floating sublayer from a second bulk sublayer located below the floating sublayer.

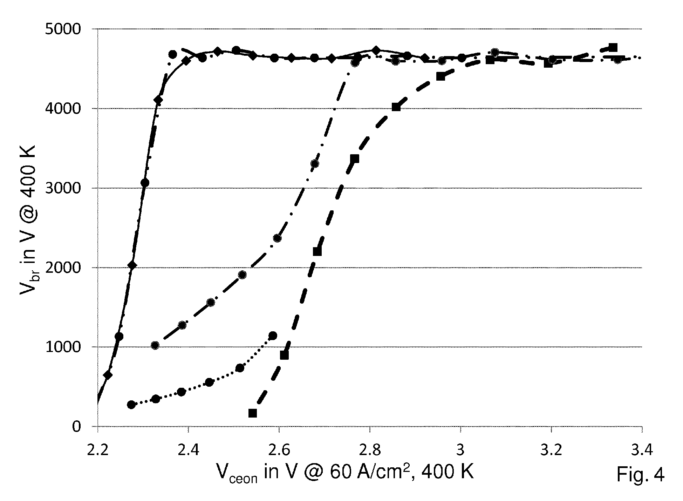

Fig. 4 shows simulation results represented by TYPE2 trade-off curves for semiconductor devices in accordance with the present invention based on an IGBT cell design as shown in Fig. 3. The p-doped floating regions 11 were assumed to have a thickness *D*_{f}= 1 µm and a doping concentration of *N*_{float} = 1.0·10¹⁸ cm⁻³, and to form a grid with a period of Λ*_{y}* = 10 µm at a distance of 10 µm from the first main side, i.e. at a depth of *x* = *d*_{float} = 10 µm. All other parameters were chosen identical to the prior art SPT+ IGBT discussed earlier. The dotted line represents simulation results obtained for a first planar IGBT cell design (to be referred to as IGBT cell design 1 in what follows) with width *w*_{f} = 2.0 µm and spacing *s*_{f} = 8.0 µm of the p-doped floating regions 11, and for doping concentrations *N*ₑₙₕ of the n-doped enhancement regions between *N*ₑₙₕ = 1.0.10¹⁷ cm⁻³ and *N*ₑₙₕ = 1.5.10¹⁷ cm⁻³. The dashed-dotted line represents simulation results obtained for a second planar IGBT cell design (to be referred to as IGBT cell design 2 in what follows) with width *w*_{f} = 4.0 µm and spaciing s_{f} = 6.0 µm of the p-doped floating regions 11, with doping concentrations *N*ₑₙₕ of the n-doped enhancement regions between *N*ₑₙₕ = 4.0·10¹⁶ cm⁻³ and *N*ₑₙₕ = 1.5.10¹⁷ cm⁻³. The solid line represents simulation results obtained for a third planar IGBT cell design (to be referred to as IGBT cell design 3 in what follows) for width *w*_{f} = 6.4 µm and spacing s_{f} = 3.6 µm of the p-doped floating regions 11, with doping concentrations *N*ₑₙₕ of the n-doped enhancement regions between *N*ₑₙₕ = 1.0·10¹⁷ cm⁻³ and *N*ₑₙₕ = 1.9-10¹⁷ cm⁻³. The dashed double-dotted line represents simulation results obtained for a fourth planar IGBT cell design (to be referred to as IGBT cell design 4 in what follows) width *w*_{f} = 6.8 µm and spacing *s*_{f} = 3.2 µm of the p-doped floating regions, with doping concentrations *N*ₑₙₕ of the n-doped enhancement regions between *N*ₑₙₕ = 1.0·10¹⁷ cm⁻³ and *N*ₑₙₕ = 2.0·10¹⁷ cm⁻³. For easier comparison, the curve from Fig. 2 is also shown, as a dashed line.

As may be seen from the various curves in Fig. 4, significantly increased breakdown voltages may be achieved by means of the buried grid of p-doped floating regions 11 for on-state voltage drops *V*_{ce,on} < 3.0 V, and in particular for on-state voltage drops *V*_{ce,on} in a range 2.2 V < *V*_{ce,on} < 2.6 V. where a reduction in on-state voltage drop over the prior art SPT+ IGBT by several hundreds of mV may be achieved.

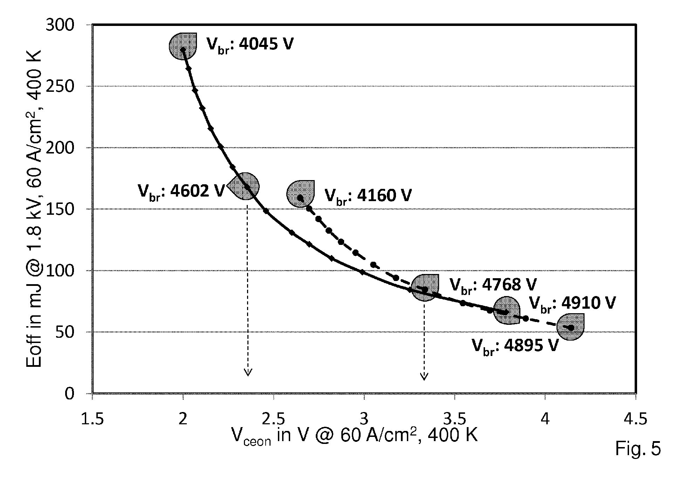

Fig. 5 shows simulation results represented by a TYPE1 trade-off curve for a semiconductor device in accordance with the present invention based on the IGBT cell design as shown in Fig. 3. The solid curve shows *V*_{ce,on} vs. *E*_{off} for IGBT cell design 3 as described in the previous, for doping concentrations of the p-doped collector layer *N*_{c} between 1.25-10¹⁷ cm⁻³ and 7.0·10¹⁷ cm⁻³. The dashed curve shows the TYPE1 trade-off curve obtained through numerical simulation for the 3.3 kV prior art SPT+ IGBT as shown in Fig. 2 for comparison. A few breakdown voltages along these two curves are highlighted; wherein the discrete points "V_{br}: 4602 V" and "V_{br}: 4768 V" correspond to identical doping concentrations of the p-doped collector layer of *N*_{c} = 3.0.10¹⁷ cm⁻³. As the vertical arrows below the curves indicate, a reduction in on-state voltage drop by one Volt is achievable at the cost of only slightly decreased breakdown voltage; albeit at increased switching losses *E*_{off}.

For IGBT cell design 3 as described above, a variation of the doping concentration *N*_{float} of the p-doped floating regions 11 within a range between 1.0·10¹⁶ cm⁻³ and 1.0·10²⁰ cm⁻³ was also considered. Key electrical performance data is summarized in the following table:

| *N*_{float} | *V*_{ce,on}/V | *E*_{off}/mJ | *V*_{br}/V |
|---|---|---|---|
| 1.0.10¹⁶ cm⁻³ | 2.203 | | 541.99 |
| 1.0.10¹⁷ cm⁻³ | 2.248 | 200.57 | 3251.14 |
| 1.0.10¹⁸ cm⁻³ | 2.401 | 148.6 | 4768.13 |
| 1.0.10¹⁹ cm⁻³ | 2.48 | 123.89 | 4633.72 |
| 1.0.10²⁰ cm⁻³ | 2.535 | 111.31 | 4658.39 |

For the breakdown voltage *V*_{br}, the numerical simulation results indicate that the doping concentrations *N*_{float} of the p-doped floating regions below 1.0.10¹⁸ cm⁻³ do not appear well suited to satisfy the request for maintaining a high breakdown voltage. The transition to acceptably high values for the breakdown voltage *V*_{br} occurs between 1.0·10¹⁷ cm⁻³ < *N*_{float} <1.0·10¹⁸ cm⁻³. Due to the very low breakdown voltage obtained for the *N*_{float} = 1.0·10¹⁶ cm⁻³, simulating of a turn-off at a voltage *\*/_{DC}=1800 V was not possible for this case. The increase in the on-state voltage drop with *N*_{float} is assumedly caused by a reduction of an effective spacing between the p-doped floating regions 11; where a significant degree of current encroachment may be expected. The reduction of turn-off switching losses with increasing *N*_{float}, allows for further improvement of the TYPE1 trade-off.

As a closer analysis of simulation results, in particular electron and hole density distributions throughout the IGBT cell for a static on-state condition at a current density of 60 A/cm² revealed, ambipolar conditions (electron density equals hole density) prevail both above and below the grid of p-doped floating regions 11. However, there is a discontinuity in the plasma concentrations on a cathode oriented side and an anode oriented side emerging with the increase of *N*_{float}. This plasma discontinuity is relatively small for *N*_{float} =1.0·10¹⁶ cm⁻³, where the plasma concentration on both sides of the grid of p-doped floating regions 11 approximately equals the one found for the prior art 3.3 kV SPT+ IGBT, namely has a level of close to *N*ₚₗₐₛₘₐ = 1.6·10¹⁶ cm⁻³. With increasing floating island doping, the plasma discontinuity increases to reach a level where *N*ₚₗₐₛₘₐ = 2.1·10¹⁶ cm⁻³ above the buried grid of p-doped floating regions 11 (i.e. on the cathode side), and *N*ₚₗₐₛₘₐ = 0.9·10¹⁶ cm⁻³ below the grid of p-doped floating regions 11. The reduced anode side plasma concentration below the grid of p-doped floating regions 11 proceeds several tenths of microns in the direction of the anode. This reduced plasma concentration level is deemed responsible for the lower switching losses as well as the increased on-state voltage drop at higher doping concentrations of the p-doped floating regions 11 as shown in the table above. On the other hand, due to its action as a "plama transformer", the buried grid of p-doped floating regions 11 increases the plasma concentration in an area of the IGBT cell neighbouring the cathode and the p-base. At this location, plasma concentrations are generally low for ordinary IGBT geometries and cause the rather high on-state voltage drops. Note that the plasma concentration below the buried grid of p-doped floating regions 11 may be varied through the doping concentration *N*_{c} of the p-doped collector layer.

In addition to the plasma density discontinuity just described, it was found that a current discontinuity starts to develop at doping concentrations *N*_{float} of the p-doped floating regions 11 above 1.0·10¹⁸ cm⁻³ in an area above the grid of p-doped floating regions 11. Most prominent is a high peak of a hole current density evolving within the p-doped floating regions 11. The p-doped floating regions 11 become virtually non-transparent for electrons at doping concentrations of *N*_{float} > 1.0·10¹⁸ cm⁻³. The high peaks in the hole current density within the p-doped floating regions 11 do not correspond to a vertical current flow from anode to cathode, but are caused by a lateral flow of holes (collection at the anode side - emission at the cathode side) in the buried grid of p-doped floating regions 11.

A closer look at the electron and hole densities obtained by means of the numerical simulation reveals that only small quantities of electrons penetrate the p-doped floating regions 11 from the cathode side 101, where a metal-oxide-silicon (MOS) channel region is located. Within the p-doped floating regions 11 the electron density decreases in a direction towards the anode side 102. At the same time, a strong injection of holes from the p-doped floating regions 11 takes place in a direction towards the cathode side 101.

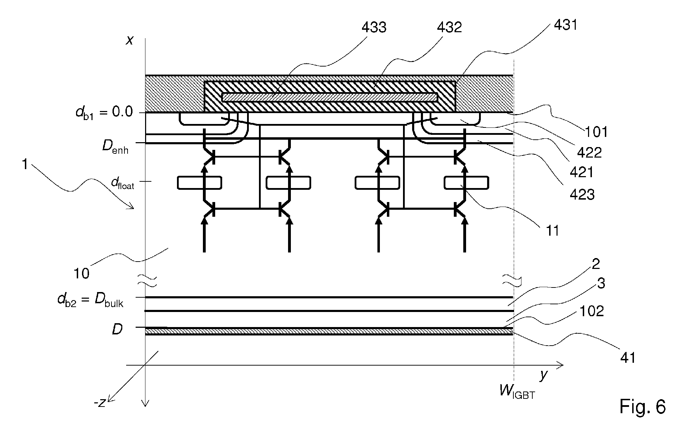

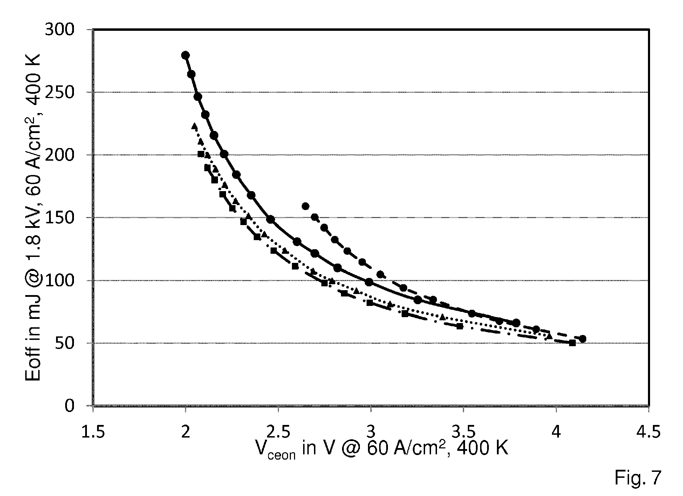

The arrangement of the buried grid of p-doped floating regions 11, a portion of the n-drift layer on the cathode side of the p-doped floating regions 11 and p-base constitutes a new embedded metal-oxide-silicon (MOS) controlled IGBT structure with high current amplification due to the high doping of the p-doped floating regions 11 - which act as floating p-emitters with high injection efficiency - and a thin base region 421 (depth of the buried grid from the cathode), as illustrated in Fig. 6, which shows an equivalent electric circuit model related to a semiconductor device in accordance with the present invention as shown in Fig. 3, which illustrates a physical mechanism of the buried grid of p-doped floating regions 11 as an effecitve cathode-sided partial or auxiliary IGBT with high α (primarily due to a small effective thickness of its base), which enhances a plasma density at the cathode . A bipolar action of the effective cathode-sided partial or auxiliary IGBT, which may be regarded as an embedded MOS controlled IGBT, compensates an increased resistance for electrons due to current encroachment between the p-doped floating regions 11. Due to high current amplification, only very little electron current from the MOS gate is needed to generate the PNP transistor action. The major part of the electron current proceeds towards the anode side, causing the collector to inject holes into the main part of the n-doped bulk layer. Most of these holes get collected on the anode side of the buried grid of p-doped floating regions 11. In consequence, the inventive IGBT cell design not only allows a reduction of on-state voltage; it may be regarded as an IGBT-in-IGBT concept with the embedded MOS controlled IGBT as described above, which may be regarded as a new class of MOS controlled power devices with inherently better TYPE1 trade-offs compared to the prior art 3.3 kV SPT+ IGBT reference. Fig. 7 shows simulation results represented by a TYPE1 trade-off curves for IGBT cell design 3 with increasing doping concentrations of the p-doped floating regions 11. The TYPE1 trade-off of the prior art reference 3.3 kV SPT+ IGBT is again shown as a dashed line for comparison. The solid curve corresponds to the solid curve from Fig. 5, i.e. a doping concentration of the p-doped floating regions 11 of *N*_{float} = 1.0·10¹⁸ cm⁻³. The dotted curve corresponds to a doping concentration of the p-doped floating regions 11 of *N*_{float} = 1.0.10¹⁹ cm⁻³. Most preferably, a value of *N*_{float} = 1.0-10²⁰ cm⁻³ is chosen for the doping concentration of the p-doped floating regions 11, for which simulation results are shown as dash-dotted curve. For an on-state voltage drop of about three volt, *E*_{off} may be reduced from 110 mJ/cm² to 80 mJ/cm² as compared to the prior art reference 3.3 kV SPT+ IGBT. At 3.3 V on-state voltage drop, the prior art reference 3.3 kV SPT+ IGBT generates 85 mJ/cm² switching loss; on state voltage drop may be reduced by as much as one Volt down to 2.3 V, whereby switching losses of only 140 mJ/cm² will be incurred.

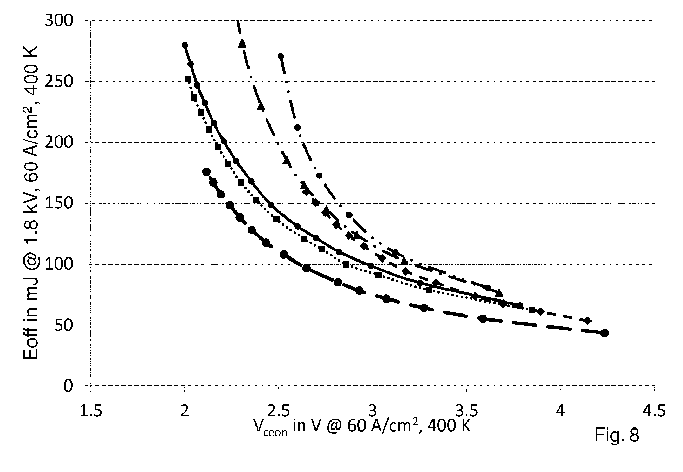

Preferably, the grid of p-doped floating regions 11 is arranged at a distance x_{float} from the first main side with *x*_{float} < 20 µm, most preferably *x*_{float} < 10 µm, as was surprisingly observed by means of numerical simulation. Fig. 8 shows simulation results represented by TYPE1 trade-off curves for IGBT cell design 3 for different distances of the grid of p-doped floating regions 11 from the first main side. The TYPE1 trade-off of the prior art reference 3.3 kV SPT+ IGBT is again shown as a dashed line for comparison. The solid curve corresponds to the solid curve from Fig. 5, i.e. with the grid of p-doped floating regions 11 located at *x*_{float} = 10 µm, and a doping concentration of the p-doped floating regions 11 of *N*_{float} = 1.0.10¹⁸ cm⁻³. The dash-dotted curve represents simulation results for the grid of p-doped floating regions 11 located at *x*_{float} = 20 µm, the dash-double dotted curve for the grid of p-doped floating regions 11 located at *x*_{float} = 30 µm; in both cases with a doping concentration of the p-doped floating regions 11 of *N*_{float} = 1.0·10¹⁸ cm⁻³. The dotted curve represents simulation results for the grid of p-doped floating regions 11 located at *x*_{float} = 8 µm, and a doping concentration of the p-doped floating regions 11 of *N*_{float} = 10¹⁸ cm⁻³; The dotted curve represents simulation results for the grid of p-doped floating regions 11 located at *x*_{float} = 8 µm, and a doping concentration of the p-doped floating regions 11 of *N*_{float} = 1.0·10¹⁸ cm⁻³, the thick, long-dashed curve for the grid of p-doped floating regions 11 located at *x*_{float} = 8 µm, and a doping concentration of the p-doped floating regions 11 of *N*_{float} = 1.0.10²⁰ cm⁻³. With the latter variant, switching loss at 2.3 V on-state voltage drop may be reduced even further down to down to 130 mJ/cm², i.e. a reduction in on-state voltage drop by one Volt may be achieved at about 50 % increase in *E*_{off} as compared to the prior art reference 3.3 kV SPT+ IGBT.

Surprisingly, simulation results indicate that further reduction of the depth at which the grid of p-doped floating regions 11 is located will not result in further improvement of the TYPE1 trade-off. This may be caused by a parasitic action of the very thin base PNP transistor between the first p-doped floating region directly below the p-base region. Preferably, buried grids of p-doped floating regions 11 with non-equidistant layouts (varying width and spacing of p-doped floating regions 11) are employed to allow for better control of the gain of the auxiliary IGBT.

As may be seen from Fig. 7, a significant increase of the switching loss is observed for locations of the grid of p-doped floating regions 11 at larger depths. For *x*_{float} < 20 µm, the TYPE1 trade-off even becomes worse than the trade-off curve for the prior art reference 3.3 kV SPT+ IGBT. Further was also found that IGBT cell designs with the grid of p-doped floating regions 11 located at large depths and with high collector doping concentration tend to produce turn-off failures.

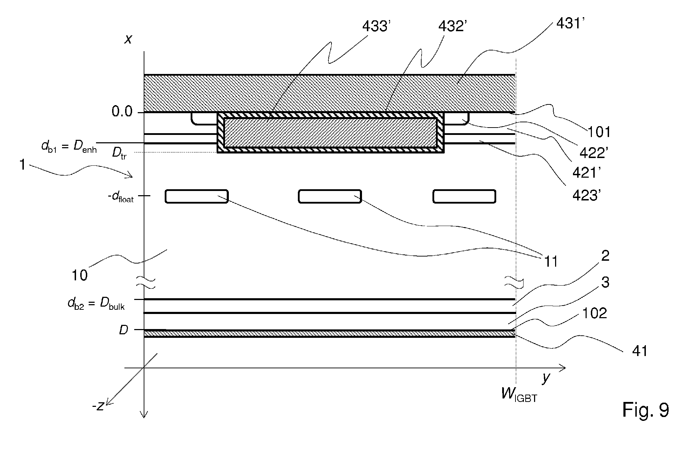

While the discussion and results presented above relate to planar IGBT cell designs, it was found that the present invention may advantageously also be applied to so called trench IGBT cell designs. Fig. 9 shows a sectional view of an individual, trench integrated gate bipolar transistor cell, as comprised by a second embodiment of a semiconductor device in accordance with the present invention. The IGBT cell is again formed in and partially around a semiconductor slab 1, which was e.g. obtained from a Silicon wafer through a plurality of process steps, generally including thinning, layer growing, implant and deposition and diffusion of dopants, and/or dicing. The semiconductor slab 1 has a first main side 101 located at *x*=0 and a second main side 102, said second main side 102 being arranged parallel to the first main side 101 at a distance *D* in (x)-direction, i.e. at x = *D*. An (n-)-doped bulk layer 10', an (n+)-doped buffer layer 2, and a (p+)-doped collector layer 3 are located between the first main side 101 and the second main side 102, and extend in a direction at least essentially parallel to the first and second main sides 101, 102 and parallel to one another. The bulk layer 10 is (n-)-doped with an at least essentially homogeneous doping concentration *N*_{D0}, preferably in a range between 5.0·10¹² cm⁻³ and 5.0·10¹⁵ cm⁻³, most preferably between 1.0·10¹³ cm⁻³ and 1.0·10¹⁴ cm⁻³, and has a thickness *D*_{bulk} preferably between 100 µm and 1.0 mm. A p-doped base region 421' extending to a depth *D*_{base} << *D*_{bulk} from the first main side 101 is formed between the first main side 101 and the bulk layer 10 at a peripheral area of the IGBT cell, and adjacent to the first main side 101. An n-doped, preferably (n+)-doped, emitter region 422' is formed between the p-doped base region 421' and the first main side 101, and contiguous to the first main side 101. A top side of the p-doped base region 421' is contiguous to the first main side outside of an area in which the n-doped emitter region 422' is formed. An n-doped enhancement region 423' extending to a depth *D*ₑₙₕ from the first main side 101, wherein *D*_{base} < *D*ₑₙₕ << *D*_{bulk} is formed between the p-doped base region 421' and the bulk layer 10, thus separating the p-doped base region 421' from the bulk layer 10.

A collector electrode 41 is provided on the second main side, adjacent and contiguous to the collector layer 3, and with an ohmic contact formed between drain electrode 41 and collector layer 3. An emitter electrode 431 is provided contiguous to the first main side 101; and also with an ohmic contact formed between emitter electrode 431 and semiconductor slab 1, in particular between the emitter electrode 431 and both emitter region 422' and p-doped base region 421'. A trench gate electrode 433' is disposed between the first main side 101 and the bulk layer 10 in a horizontal central area of the trench IGBT cell, and electrically insulated from emitter electrode 431' and semiconductor slab 1 by a trench gate insulator 432', which surrounds the trench gate electrode 433'. The trench gate electrode 433' has a thickness *D*ₜᵣ > *D*_{base}, preferably_*D*ₜᵣ > *D*ₑₙₕ, and is disposed adjacent to the emitter region 422', the p-doped base region 421', and preferably the enhancement region 423'. Emitter electrode 431 is also referred to as cathode or cathode electrode, collector electrode 41 as anode or anode electrode

A plurality of isolated, p-doped, preferably (p+)-doped, floating regions 11 having a net doping concentration *N*_{float} > *M*_{D0} are formed in the bulk layer at between a first distance *d*_{f1} and a second distance *d*_{f2} > *d*_{f1} from the first main side 101, i.e. at a depth *x* = *d*_{float} with *d*_{float} = (*d*_{f2} - *d*_{f1})/2 and *D*ₑₙₕ < *d*_{float} << *D*_{bulk}, wherein preferably 5*D*_{base} < *d*_{float} < 20*D*_{base} and/or 2*D*ₑₙₕ < *d*_{float} < 10*D*ₑₙₕ also hold. In a vertical direction, the p-doped floating regions 11 have a thickness *D*_{f} := *d*_{f2} - *d*_{f1} with *D*_{f} << *D*_{bulk}, preferably D_{f} < *D*_{bulk}/10, most preferably *D*_{f} < *D*_{bulk}/100. In a first horizontal direction, corresponding to a *y*-direction in Fig. 3, the p-doped floating regions 11 have a width *w*_{f}, typically in a range 0,5 µm < *w*_{f} < 10 µm, preferably 1 µm < w_{f} < 3 µm. Neighboring p-doped floating regions 11 are spaced apart from one another with respect to the *y*-direction with a spacing s_{f} typically in a range 1 µm < *s*_{f} < 10 µm, preferably 2 µm < *s*_{f} < 5 µm.

An actual IGBT-type semiconductor device comprises a plurality, typically several hundred to a few thousands, of individual cells as shown in Fig. 3, arranged contiguous to one another in *y*-direction, each cell having a width *w*_{IGBT} typically in a range 20 µm < *w*_{IGBT} < 200µm, preferably 40 µm < *w*_{IGBT} < 100 µm. The laterally contiguous bulk layers 10 of the individual IGBT cells thus form a contiguous bulk layer in the IGBT-type semiconductor device Likewise, the p-doped floating regions 11 form a buried grid with a period Λ*_{y}* = *w*_{f} + *s*_{f} within the contiguous bulk layer of the IGBT-type semiconductor device.

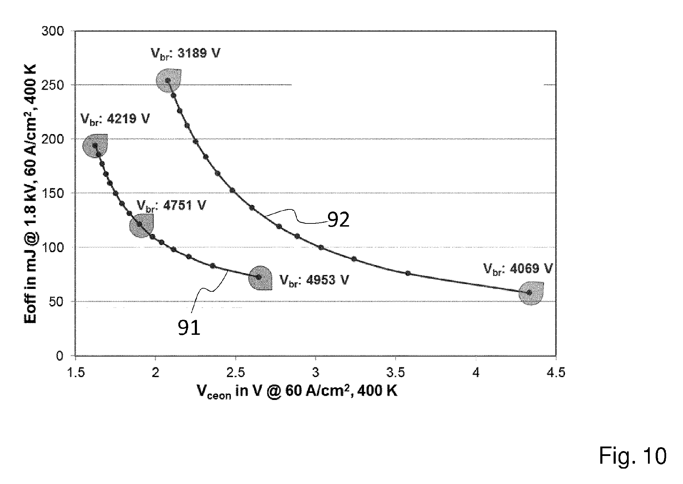

Fig. 10 shows simulation results represented by a TYPE1 trade-off curve for the second embodiment of a semiconductor device in accordance with the present invention based on trench IGBT cell designs as shown in Fig. 9. Curve 91 shows *V*_{ce,on} vs. *E*_{off} for the trench IGBT cell design described in the previous paragraph, assuming hard inductive turn-off of 60 A/cm versus a DC voltage *V*_{DC} = 1800 V at a device temperature of 400 K, wherein a circuit used for the simulation mimics a typical 3.3 kV application. Curve 92 shows a TYPE1 trade-off curve obtained through numerical simulation for a 3.3 kV prior art reference trench IGBT with enhancement layer, but without p-doped floating regions. Again, a few breakdown voltages along these two curves are highlighted. Trade-off curve 91 for the trench IGBT design with buried grid of p-doped floating regions is shifted to lower on-state voltages by about 0.9 to 1 V. An optimized trench IGBT design with buried grid thus allows to push the on-state voltage drop below 2 V while maintaining the turn-off loss at 100 mJ/cm² assuming turn-off conditions as described above. If an increase of turn-off losses to between 150 mJ/cm² and 200 mJ/cm² is acceptable, on-state voltage drops close to 1.5 V come into reach.

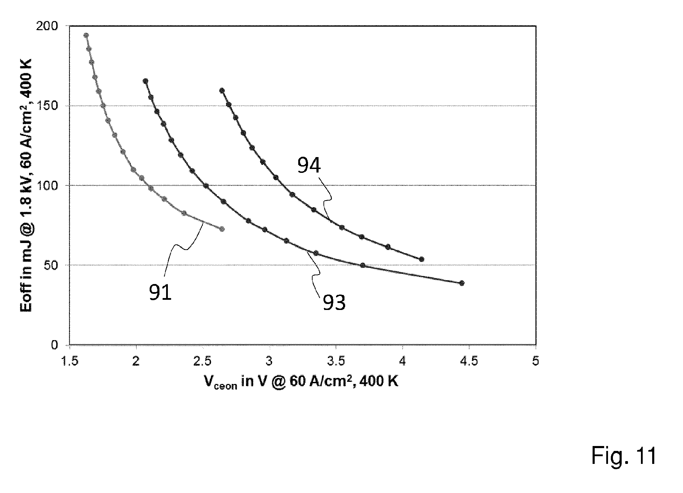

Fig. 11 shows simulation results represented by TYPE1 trade-off curves. Curve 91 again shows *V*_{ce,on} vs. *E*_{off} for the trench IGBT cell design as described above. Curve 93 shows *V*_{ce,on} vs. *E*_{off} for an optimized, planar IGBT cell design with p-doped floating regions 11. Curve 94 corresponds to the TYPE1 trade-off curve as shown in Fig. 1 and obtained through numerical simulation of the prior art 3.3 kV SPT+ IGBT used for reference. As may be seen, the planar IGBT with optimized design permits a 0.5 to 0.6 V reduction of the on-state voltage drop (assuming the same turn-off loss, for example 100 mJ/cm²). Pairing a trench IGBT with an identical buried grid of p-doped floating regions permits to reduce *V*_{ce,on} by another 0.5 V. At 1.5 V on-state voltage drop, the trench IGBT cell design with buried grid ofp-doped floating regions 11 may even rival thyristors of comparable blocking capability.

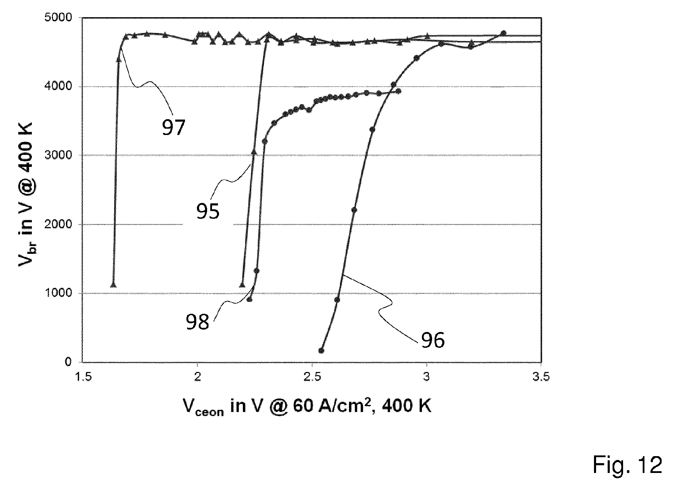

Fig. 12 shows simulation results represented TYPE2 trade-off curves *V*_{br} vs. *V*_{ce,on} for both planar and trench IGBT cell designs, both with and without buried grid of p-doped floating regions. Curve 95 corresponds to the dashed-double-dotted line from Fig. 4; curve 96 to the dashed curve from Fig. 4. Curve 97 shows *V*_{br} vs. *E*_{off} for the trench IGBT cell design as shown in Fig. 9 and described above, again assuming hard inductive turn-off of 60 A/cm versus a DC voltage *V*_{DC} = 1800 V at a device temperature of 400 K, and using a circuit mimicking a typical 3.3 kV application. Curve 98 shows *V*_{br} vs. *E*_{off} obtained through numerical simulation for a 3.3 kV prior art reference trench IGBT with enhancement layer, but without p-doped floating regions. It is possible to maintain breakdown voltage further down to lowest on-state voltage than what would be achievable with a planar IGBT / buried grid approach.

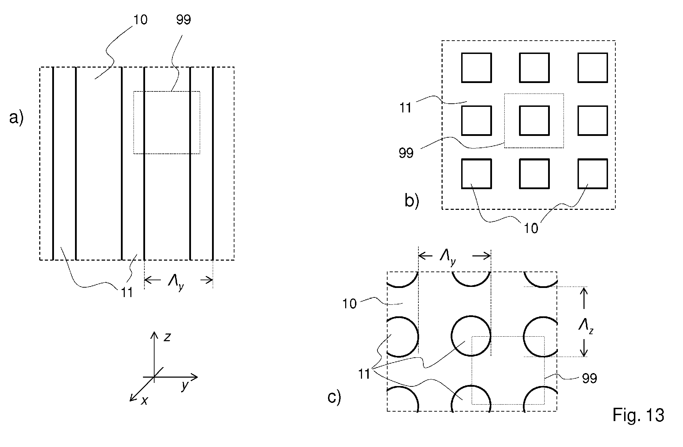

Preferably, in embodiments as described above, the p-doped, preferably (p+)-doped, floating regions 11 extend continuously and/or uniformly in a second horizontal direction represented by the z-direction of Fig. 3, 6 and 9, corresponding to a third spatial dimension of the semiconductor device. The p-doped floating regions 11 thus form parallel stripes into the third dimension. Alternatively, p-doped, preferably (p+)-doped, floating regions 11 may also form a grid in the third dimension, preferably periodic in *z*-direction with a period of Λ_{z}. Fig. 13 schematically shows partial top views of cuts at *x* = *d*_{float} parallel to the *y*-*z*-plane through various semiconductor devices in accordance with the present invention, having different, exemplary p-doped floating region layouts. Examplary cell boundaries of IGBT cells are indicated by rectangle 99.

Preferably, in embodiments as described above and below, the conductivity types may be interchanged, i.e. all (n-)-, n-, or (n+)-layers and regions as described may be replaced by (p-)-, p-, or (p+)-layers and regions, respectively, and vice versa.

Unless stated otherwise, all doping concentrations *N* referred to in this patent application are net doping concentrations, where *N* is defined as *N*:= *N_{D}* - *N*_{A} for regions or layers in which a total density of donors *N*_{D} is larger than a total density of acceptors *N*_{A}, i.e. *N*_{D} > *N*_{A}, i.e. in particular for n-doped regions or layers; and as *N* := *N*_{A} - *N*_{D} for regions or layers in which a total density of donors *N*_{D} is smaller than a total density of acceptors *N*_{A}, i.e. in particular for p-doped regions or layers. Preferably, in embodiments as described above, suffixes "-" and "+" after doping type indicators p, n are used to express relative net doping concentrations. In particular, a net doping concentration *N*(n+) of each (n+)-doped region or layer is larger than a net doping concentration *N*(n) of each (n)-doped region or layer, which in turn is larger is larger than a net doping concentration *N*(n-) of each (n-)-doped region or layer. Likewise, a net doping concentration *N*(p+) of each (p+)-doped region or layer is larger than a net doping concentration *N*(p) of each (p)-doped region or layer, which in turn is larger than a net doping concentration *N*(p-) of each (p-)-doped region or layer. Preferably, *N*(n+) ≥ *N*(p), *N*(n) ≥ *N*(p-), *N*(p+) ≥ *N(*n) and/or *N*(p) ≥ *N*(n-); most preferably, *N*(n+) > *N*(p), *N*(n) > *N*(p-), *N*(p+) > *N*(n) and/or *N*(p) > *N*(n-) also hold. On the other hand, where identical suffixes are used with regard to different layers or regions, this shall preferably not be construed to imply that the doping concentrations of said different layers or regions are identical.

Preferably, in embodiments as described above and below, where a doping concentration or net doping concentration of a region or layer is referred to, this is preferably to be understood as a maximum net doping concentration within said region or layer. In particular for doped regions or layers which were formed including a dopant diffusion process step, a local net doping concentration decays in one or more spatial directions from an area within the region or layer, in which area the local doping concentration equals the maximum net doping concentration.

Preferably, in embodiments as described above and below, the bulk layer 10, which throughout technical, scientific and patent literature is frequently referred to as drift layer, is a layer of unamended net doping concentration by the dopant diffusion process step, i.e. having the net doping concentration as achieved preferably by epitaxial growth of the bulk layer 10. Exemplarily, the bulk layer 10 has a constantly low net doping concentration *N*_{D0}. Therein, the substantially constant net doping concentration of the bulk layer 10 means that the net doping concentration is substantially homogeneous throughout the bulk layer 10, however without excluding that fluctuations in the net doping concentration within the bulk layer 10 being in the order of a factor of one to five may possibly be present due to e.g. fluctuations in the epitaxial growth process. The final bulk layer thickness and net doping concentration is chosen due to the application needs.

If a region or layer is referred to as being formed or as being provided in the bulk layer (or any other comprising layer or region), it is understood that within the former region or layer the physical properties, in particular the doping type and concentration, of said former region or layer prevail over the properties, in particular the doping type and concentration, of the bulk layer (or the other comprising layer or region as referred to above). On the other hand, when the physical properties, in particular the doping type and concentration, of the bulk layer (or the other comprising layer or region as referred to above) are referred to, physical properties, in particular the doping type and concentration, of the regions or layers formed in the latter or provided in the latter are not taken into account.

Preferably, in embodiments as described above and below, wide bandgap semiconductor materials, in particular SiC, AlN, GaN, or BN may be used for the semiconductor slab 1 instead of Silicon, preferably with all vertical dimensions as specified above and below decreased by a factor of at least 3, most preferably greater than 6.

In embodiments as described above, the term "vertical" refers to a vertical direction represented by the positive x-direction in the Figures and corresponding to a first spatial dimension of the semiconductor device perpendicular to the first main side 101. In particular, unless otherwise stated, terms "up, "down", "top", "bottom", "above", "below", "underneath", "depth", "thickness", etc. refer to an orientation, extension, dimension, distance, (relative) location etc. with respect to the vertical direction. Likewise, the term "lateral" refers to a first horizontal direction represented by the positive y-direction in the Figures and corresponding to a second spatial dimension of the semiconductor device, parallel to the first main side 101. In particular, unless otherwise stated, the term "width" refers to an extension, dimension, distance, etc. in the first horizontal direction. The width shall refer to a maximum extension of a layer in a plane parallel to the first main side.

Unless stated otherwise, it is assumed that throughout this patent application, a statement *a* ≈ *b* implies that |*a*-*b*|/(|*a*|+|*b*|) < 10, preferably |*a*-*b*|/(|*a*|+|*b*|) < 100, wherein a and *b* may represent arbitrary variables as described and/or defined anywhere in this patent application, or as otherwise known to a person skilled in the art. Further, a statement that *a* is at least approximately equal or at least approximately identical to *b* implies that *a* ≈ *b*, preferably *a* = *b*. Further, unless stated otherwise, it is assumed that throughout this patent application, a statement *a* >> *b* implies that *a* > 10*b*, preferably *a* > 100*b*; and statement *a* << *b* implies that 10*a* < *b*, preferably 100*a* < *b*.

It should be noted that the term "comprising" does not exclude other features, in particular elements or steps, and that the indefinite article "a" or "an" does not exclude the plural. Also elements described in association with different embodiments may be combined. It should also be noted that reference signs in the claims shall not be construed as limiting the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

### List of Reference Signs

- 1: semiconductor slab
- 10: bulk layer
- 101: first main side
- 102: second main side
- 11: p-doped floating region
- 2: buffer layer
- 3: collector layer
- 41: collector electrode
- 421, 421': base region
- 422, 422': emitter region
- 423, 423': enhancement region
- 431, 431': emitter electrode
- 432, 432': insulator
- 433: planar gate electrode
- 433': trench gate electrode
- 91, 92, 93, 94: TYPE1 trade-off curves
- 95, 96, 97, 98: TYPE2 trade-off curves
- 99: Exemplary IGBT cell boundaries

## Claims

1. A semiconductor device comprising a semiconductor slab (1), in particular a semiconductor wafer or semiconductor die, said semiconductor slab (1) having a first main side (101) and a second main side (102), said second main side (102) being parallel to the first main side (101) at a distance with respect to a first direction; the semiconductor device further comprising
a) an insulated gate bipolar transistor cell comprising an emitter electrode (431, 431') formed on the first main side (101) and a collector electrode (41) formed on the second main side (102), the IGBT cell further comprising between the first main side (101) and the second main side (102):
i) a bulk layer (10) of a first conductivity type extending in the first direction between a distance *d*_{b1} from the first main side (101) with *d*_{b1} >= 0 and a distance *d*_{b2} from the first main side (101) with *d*_{b2} > *d*_{b1}, and in a second direction perpendicular to the first direction, said bulk layer (10) being adjacent to the first main side (101),
ii) a collector layer (3) of a second conductivity type, which is different from the first conductivity type, said collector layer being adjacent, preferably contiguous, to the second main side (102), and electrically connected to the collector electrode (41),
the IGBT cell further comprising
iii) a base region (421, 421') of the second conductivity type, provided between the first main side (101) and the bulk layer (10),
iv) an emitter region (422, 422') of the first conductivity type, provided between the first main side (101) and the base region (421, 421'),
v) an enhancement region (423, 423') of the first conductivity type, provided between the bulk layer (10) and the base region (421, 421'),
b) wherein the emitter electrode (431, 431') is electrically connected to the emitter region (422, 422') and the base region (421, 421'), and
c) a gate electrode (433) is arranged adjacent to the first main side (101), and electrically insulated from the semiconductor slab (1) and from the emitter electrode (431, 431'),
**characterized in that**
d) a plurality of, preferably at least 4, floating regions (11) of the second conductivity type are provided in the bulk layer (10) between a first distance *d*_{f1} from the first main side (101) and a second distance *d*_{f2} from the first main side (101), and spaced apart from one another with respect to the second direction.

2. The semiconductor device according to claim 1, **characterized in that** the plurality of floating regions (11) are located at a depth *d*_{float} = (*d*_{f2} - *d*_{f1})/2 from the first main side (101), with 10*d*_{float} < *D*_{bulk}, preferably 30*d*_{float} < *D*_{bulk}, wherein *D*_{bulk} = *d*_{b2} - *d*_{b1} is a thickness of the bulk layer.

3. The semiconductor device according to one of the previous claims, **characterized in that** the floating regions (11) are located at a depth *d*_{float} = (*d*_{f2} - *d*_{f1})/2 from the first main side (101), with 20 µm > *d*_{float} > 5.0 µm, preferably 12µm > *d*_{float} > 7.0 µm.

4. The semiconductor device according to one of the previous claims, **characterized in that** a buffer layer (2) of the first conductivity type is located between the bulk layer (10) and the collector layer (3), said buffer layer (2) having a doping concentration *N*_{buf} which is larger than a doping concentration *N*_{D0} of the bulk layer (10), where in particular *N*_{buf} > 5 *N*_{D0}.

5. The semiconductor device according to one of the previous claims, **characterized in that** a thickness *D*_{float} = *d*_{f2} - *d*_{f1} of the floating regions (11) is smaller as compared to a thickness *D*_{bulk} = *d*_{b2} - *d*_{b1} of the bulk layer (10), i.e. 30*D*_{float} < *D*_{bulk}, preferably 100*D*_{float} < *D*_{bulk}; and/or **in that** *D*_{float} < 5 µm, preferably *D*_{float} < 2 µm.

6. The semiconductor device according to one of the previous claims, **characterized in that** the doping concentration *N*_{float} of the plurality of floating regions (11) is between 1.0·10¹⁷ cm⁻³ and 5.0·10²⁰ cm⁻³, preferably between 1.0·10¹⁹cm⁻³ and 2.0·10²⁰ cm⁻³.

7. The semiconductor device according to one of the previous claims, **characterized in that** the plurality of floating regions (11) have a width of 4 µm < *w*_{f} < 8 µm, preferably 6 µm < *w*_{f} < 7 µm in the second direction.

8. The semiconductor device according to one of the previous claims, **characterized in that** a spacing s_{f} in the second direction between floating regions (11) is between 2 µm < sf < 6 µm, preferably 3 µm < s_{f} < 4 µm.

9. The semiconductor device according to one of the previous claims, **characterized in that** the insulated gate bipolar transistor cell is a planar insulated gate bipolar transistor cell.

10. The semiconductor device according to one of the previous claims, **characterized in that** the insulated gate bipolar transistor cell is a trench insulated gate bipolar transistor cell.
